Europäisches Patentamt

European Patent Office

Office européen des brevets

(11) Publication number: 0 371 557
A2

# (12) EUROPEAN PATENT APPLICATION

(21) Application number: 89202986.9

(22) Date of filing: 24.11.89

(51) Int. Cl.⁵: H01L 27/082, H01L 27/07

(30) Priority: 30.11.88 IT 662588

(43) Date of publication of application:
06.06.90 Bulletin 90/23

(84) Designated Contracting States:
DE FR GB NL

(71) Applicant: SGS-THOMSON
MICROELECTRONICS s.r.l.
Via C. Olivetti, 2
I-20041 Agrate Brianza Milano(IT)

(72) Inventor: Patti, Alfonso
Via Rosso di San Secondo 11
I-95100 Catania CT(IT)
Inventor: Moriconi, Ugo
Via Trentino 4
I-24044 Dalmine Mariano BG(IT)
Inventor: Fleres, Sergio
Via E. d'Angiò 46
I-95125 Catania CT(IT)

(74) Representative: Arena, Giovanni
Viale Certosa 135
I-20151 Milano(IT)

(54) PNP Darlington device structurally improved with regard to the integrated speed-up diode, and its manufacturing method.

(57) The integrated speed-up diode is a Schottky diode which in the integrated structure of the device is located within a delimited area of the base of the final transistor.

FIG. 3

## PNP DARLINGTON DEVICE STRUCTURALLY IMPROVED WITH REGARD TO THE INTEGRATED SPEED-UP DIODE, AND ITS MANUFACTURING METHOD

This invention refers to a PNP Darlington device which is structurally improved with regard to the integrated speed-up diode, and its manufacturing method.

Bipolar power transistors in the Darlington configuration have the drawback of being considerably slow in switching on/off. In fact, at the moment of switching, the extraction current of the charges stored in the base region has an immediate effect only on the driver transistor (T1) and a slower effect on the final transistor (T2).

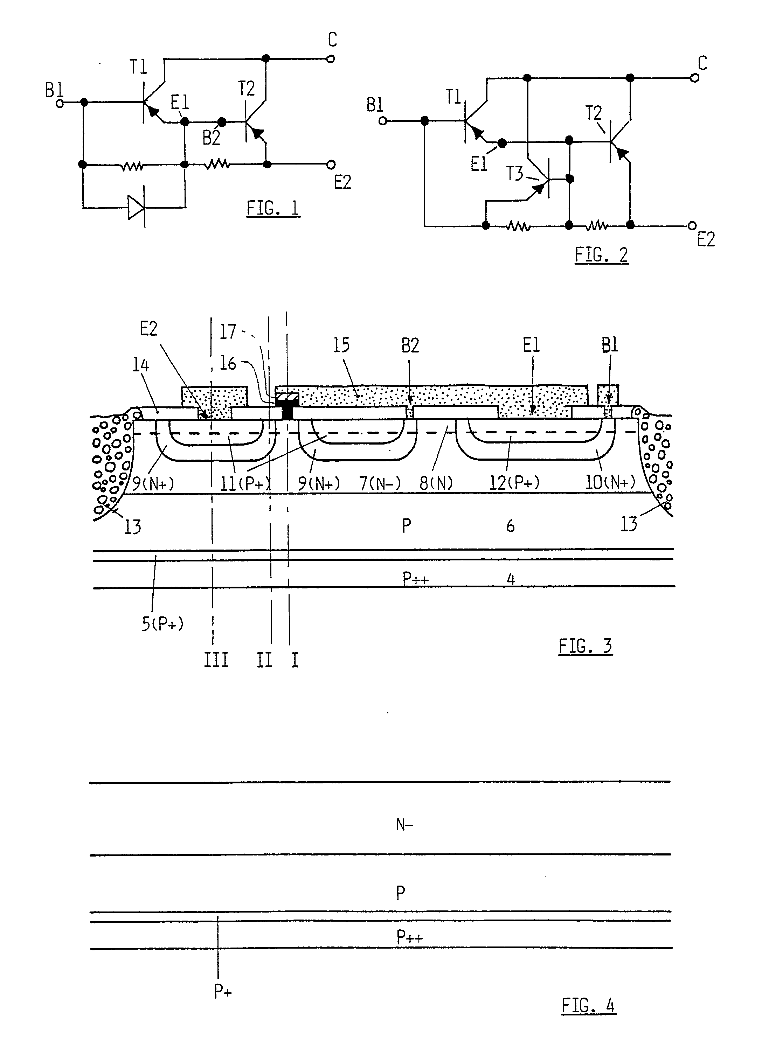

The method most commonly used in order to speed up the switching of a Darlington is to insert a speed-up diode between the base of the driver and that of the final transistor, as shown in Fig. 1. This diode can be made integrated with a very low gain speed-up transistor (T3), as shown in Fig. 2.

According to a known Darlington device and relative manufacturing method, the base of the speed-up transistor T3 is highly doped N + + in order to considerably reduce the relative gain.

This device and the relative manufacturing method give rise to a number of problems including the problematic controllability and repeatability of the electrical characteristics of the device obtained, especially in the case of a PNP Darlington device.

The scope of this invention is to provide a PNP Darlington device with improved electrical characteristics and repeatability, which lends itself to be made by means of a more easily controllable process.

The device according to the invention is characterized by the fact that the integrated speed-up diode is a Schottky diode which in the integrated structure of the de vice is located within a delimited area of the base of the final transistor. The inventive features of the relative manufacturing method are illustrated further on in the claims.

The features of the invention will be more clearly understood from the following description of a non-restrictive embodiment, with reference to the various figures shown in the accompanying drawings, in which:

Fig. 3: shows a vertical cross-sectional according to the structure of a PNP Darlington according to the invention;

Figs.4-13: show various steps in a manufacturing process suitable for obtaining the structure of Fig. 3;

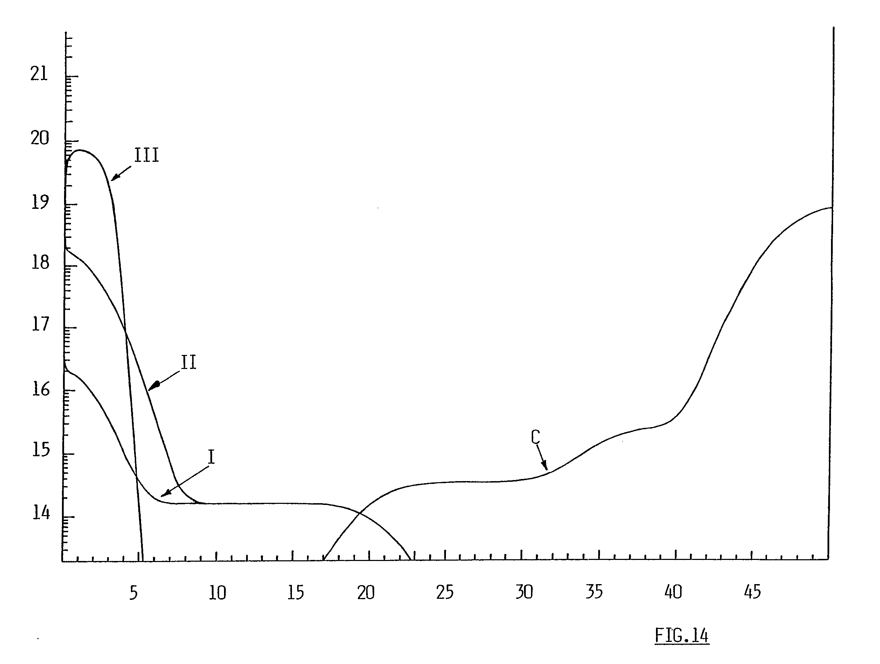

Fig.14: shows profiles of the concentrations of dopant in three sections of the structure of Fig. 3.

Fig. 3 shows a vertical cross-sectional view of the structure of a PNP Darlington device according to the invention obtained by means of the MEM technique (Multi-Epitaxial Mesa). In the figure the following references are used to illustrate the various parts:

4: P + + type silicon substrate (collector of the Darlington);

5,6: P + and P type epitaxial layers, respectively;

7: N- type epitaxial layer (bae of the Darlington);

8: N type layer;

9,10: N + type regions forming more highly doped diffused bases (in order to avoid punch-through phenomena in the Darlington obtained by means of the MEM technique), with reference 9 indicating the base of the final transistor and 10 indicating the base of the driver transistor;

11: P + type emitter region of the final transistor;

12: P + type emitter region of the driver transistor;

13: passivation glass present in "mesa" etchings;

14: oxide layer;

15: conductive material (aluminium);

16: metallic area of the Schottky junction, made of pla tinum in order to give the relative diode good electrical characteristics;

17: titanium-tungsten alloy coating placed over the platinum in order to prevent alloying between the platinum and the aluminium, without however jeopardizing the electrical connection of the two metals.

In order to ensure the formation of a Schottky junction which carries out the desired function of a speed-up diode, the area of the final transistor base where the Schottky diode is located is made with a surface concentration of dopant ranging from $10^{14}$ to $5 \cdot 10^{16}$ atoms/cm$^3$. A Darlington structured as shown in Fig. 3 can be obtained by means of a process comprising the following consecutive steps:

- growth on a P + + type substrate of P +, P, N- epitaxial layers, the latter constituting the base of the Darlington (Fig. 4);

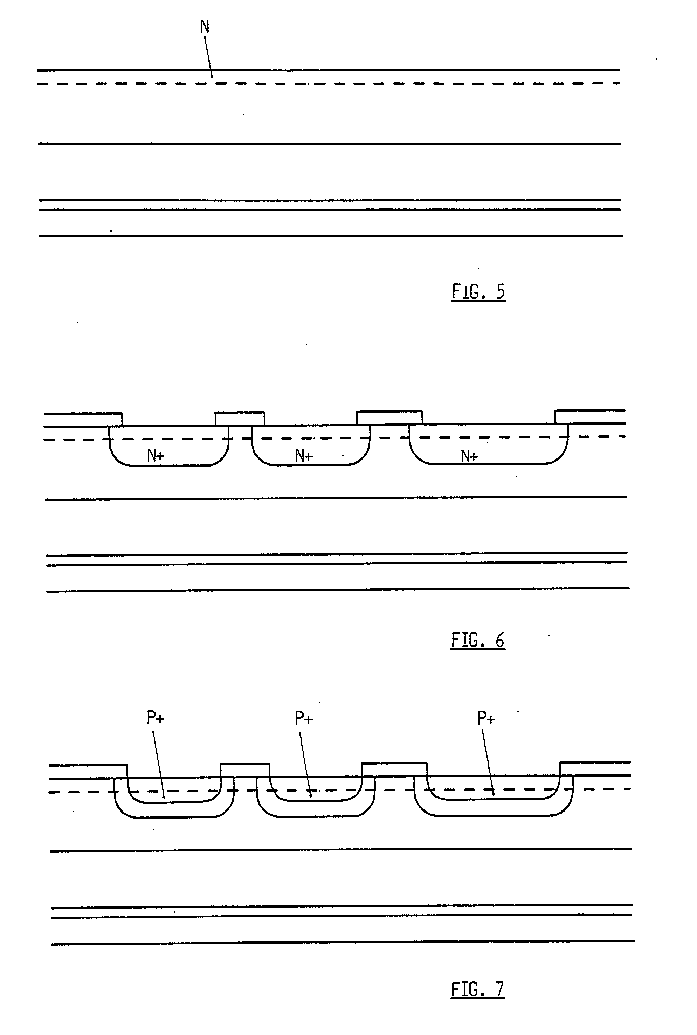

- ionic implantation of phosphorus at a dose of $6 \cdot 10^{12}$ atoms/cm$^2$ to form the Schottky junction (N type layer of Fig. 5);

- formation of the N + enriched bases of the Darlington, by means of ionic implantation of dopant at a dose of $5 \cdot 10^{14}$ atoms/cm$^2$ (Fig. 6);

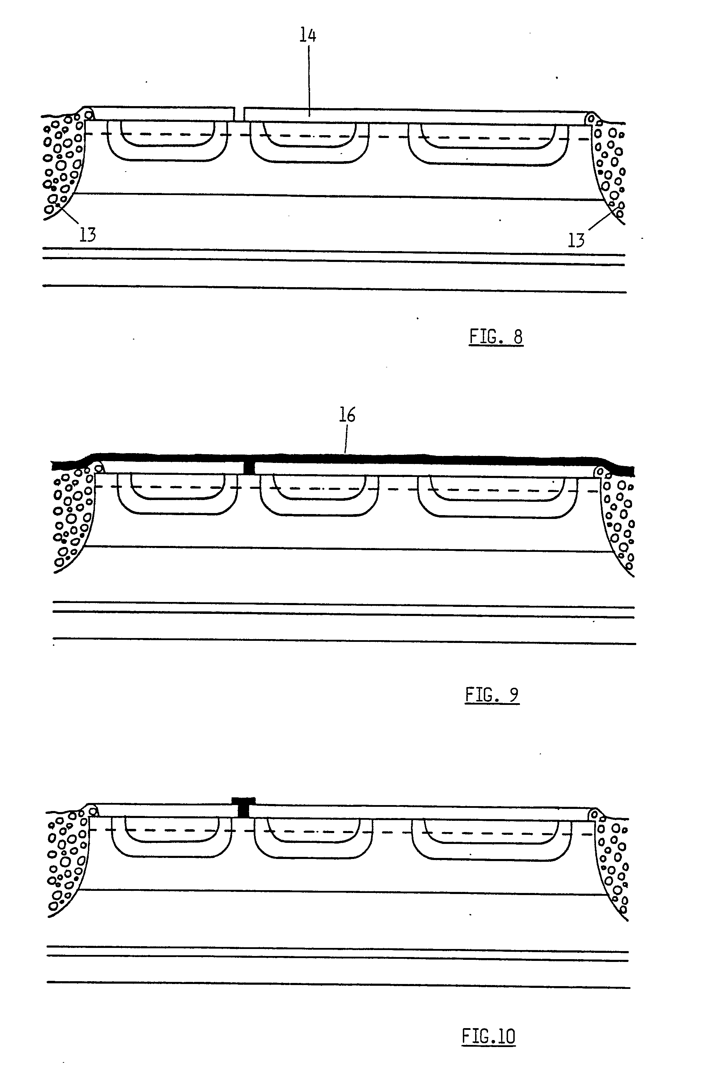

- formation of the P + emitters of the Darlington (Fig. 7);

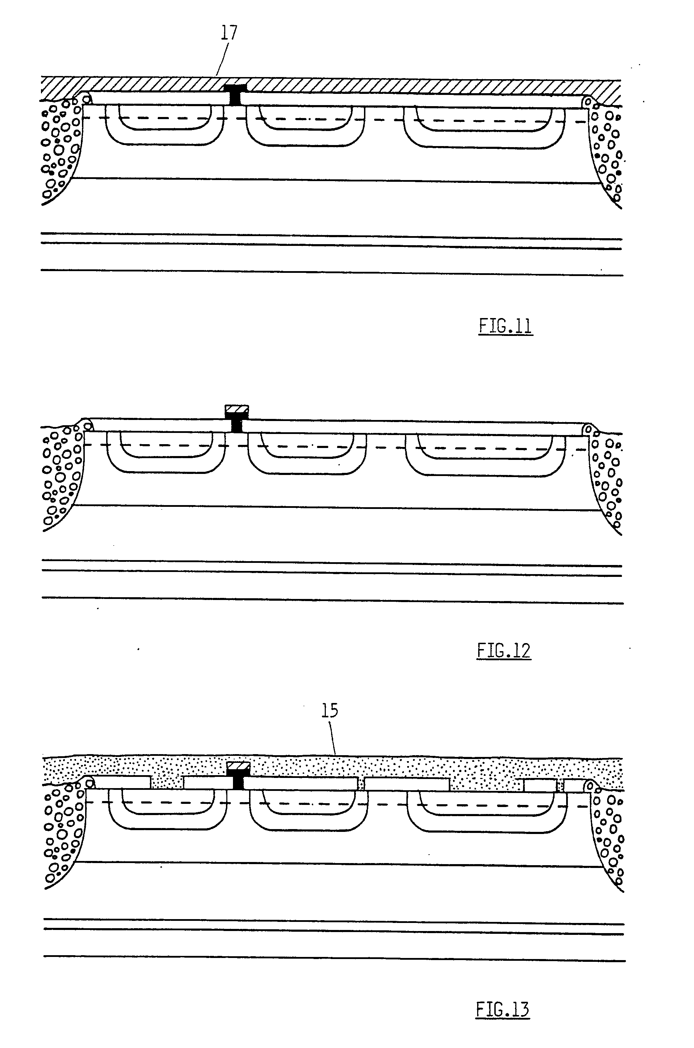

- definition of the base by "mesa" etchings;
- superficial passivation of the front with glass 13 and oxide 14;
- aperture of the Schottky contact in the oxide coating of the base region of the final transistor (Fig. 8);
- deposition by sputtering of platinum 16 and sintering of the latter (Fig. 9);
- etching of the platinum with aqua regia to isolate the portion to be used for the Schottky junction (Fig. 10);
- thermal stabilization of the platinum;
- deposition by sputtering of a layer 17 to Ti-W (Fig. 11);
- phototechnical delimitation of the Ti-W layer over the platinum zone (Fig. 12);
- aperture of the other contacts in the oxide;
- deposition of aluminium 15, by evaporation, in order to obtain the contacts (Fig. 13);
- etching the aluminium by phototechnical process to define the interconnecting metal paths (Fig. 3);
- thermal process for alloying the aluminium with the silicon;
- final passivation and definition of the areas for the connecting electrodes;
- finishing and metallization of the substrate to form the collector electrode.

The Schottky diode obtained at the end of the above described process is, as mentioned previously, free from harmful punch-through effects. The profiles of the dopant concentrations measured on its three sections (section I, II and III of Fig. 3) are given in Fig. 1. In this figure the y-coordinates are the values of the logarithm of the dopant concentrations (atoms/cm$^3$ ) and the x-coordinates are the values of the depths in um; the curve C represents the dopant concentrations in the lower collector layers.

The inventive solution has been described with reference to the more complex case of a PNP Darlington obtained by means of the MEM technique. It can, however, be applied, with obvious variations, to more simple cases of Darlingtons obtained by means of "epibase" and "planar" techniques and to the case of multistage devices composed of more than two transistors (in the case of the latter a Schottky diode will be provided for each transistor base to be sped up).

**Claims**

1. PNP Darlington device of the integrated type, comprising a driver transistor, a final transistor and a diode acting as a speed-up diode, characterized by the fact that the speed-up diode is a Schottky diode which in the integrated structure of the device is located within a delimited area of the base of the final transistor.

2. Method of manufacturing a PNP Darlington device of the integrated type, including a driver transistor, a final transistor and a diode acting as a speed-up diode, and comprising the steps of:
- growing P, N- epitaxial layers on a P+ type substrate;
- formation of the N+ enriched bases of the Darlington;
- formation of the P+ emitters of the Darlington;
- initial superficial passivation of the front with oxide;
- aperture of the contact areas in the oxide;
- deposition of aluminium on the front in order to obtain the contacts;
- etching of the aluminium to define the interconnecting metallic paths;
- thermal process for alloying the aluminium with the silicon;
- final passivation and definition of the areas for the connecting electrodes;
- finishing and metallization of the substrate to form the collector electrode;
characterized by the fact that the formation of the enriched bases of the Darlington is preceded by ionic implantation of phosphorus at a dose of approximately $6.10^{12}$ atoms/cm$^2$ and is then carried out by ionic implantation of dopant at a dose of approximately $5 \cdot 10^{14}$ atoms/cm$^2$,
and by the fact that, between the initial superficial passivation of the front and the aperture of the contact zones in the oxide, the following steps are included:
- aperture, in the oxide coating of the final transistor base region, of a window designed to form the junction of a Schottky diode;
- deposition by sputtering of platinum and sintering of the latter;
- etching of the platinum with aqua regia to isolate the area for the Schottky junction;
- thermal stabilization of the platinum;
- deposition by sputtering of a layer of Ti-W;
- phototechnical delimitation of the Ti-W layer over the platinum zone.

FIG. 1

FIG. 2

FIG. 3

FIG. 4

N

FIG. 5

N+       N+       N+

FIG. 6

P+       P+       P+

FIG. 7

14

13                                                                          13

FIG. 8

16

FIG. 9

FIG.10

FIG.11

FIG.12

FIG.13

EP 0 371 557 A2

FIG.14